**Europäisches Patentamt**

**European Patent Office**

**Office européen des brevets**

(11) Numéro de publication : **0 333 566 B1**

(12) **FASCICULE DE BREVET EUROPEEN**

(45) Date de publication du fascicule du brevet :
23.09.92 Bulletin 92/39

(51) Int. Cl.$^5$ : **H03H 17/06, // G01S13/52**

(21) Numéro de dépôt : **89400675.8**

(22) Date de dépôt : **10.03.89**

(54) **Procédé et dispositifs de translation le long de l'axe des fréquences du module de la fonction de transfert d'un filtre.**

(30) Priorité : **18.03.88 FR 8803524**

(43) Date de publication de la demande :
**20.09.89 Bulletin 89/38**

(45) Mention de la délivrance du brevet :
**23.09.92 Bulletin 92/39**

(84) Etats contractants désignés :
**DE GB IT NL**

(56) Documents cités :
**GB-A- 2 173 366**
**US-A- 4 463 356**
**IEEE TRANSACTIONS ON AUDIO AND ELEC-TROACOUSTICS, vol. AU-19, no. 1, mars 1971, pages 72-77; W. ROECKER: "The application ofdigital filters for moving target indication"**
**RCA REVIEW, vol. 32, no. 3, septembre 1971, pages 402-428; T. MURAKAMI et al.: "Clutter suppression by use of weighted pulsetrains"**
**PATENT ABSTRACTS OF JAPAN, vol. 2, no. 84, 8 juillet 1978, page 3606 E 78; & JP-A-53 48 496 (MITSUBISHI DENKI K.K.)01-05-1978**

(73) Titulaire : **THOMSON-CSF**
**51, Esplanade du Général de Gaulle**
**F-92800 Puteaux (FR)**

(72) Inventeur : **Coulmier, Jean Pol THOMSON-CSF SCPI-51, Esplanade du Général de Gaulle Cédex 67**
**F-92045 Paris la Défense (FR)**
Inventeur : **Kunegel, Jacques THOMSON-CSF SCPI-51, Esplanade du Général de Gaulle Cédex 67**
**F-92045 Paris la Défense (FR)**
Inventeur : **Lepère, Guy THOMSON-CSF SCPI-51, Esplanade du Général de Gaullel Cédex 67**
**F-92045 Paris la Défense (FR)**

(74) Mandataire : **Benoit, Monique et al THOMSON-CSF SCPI**
**F-92045 PARIS LA DEFENSE CEDEX 67 (FR)**

EP 0 333 566 B1

## Description

L'invention concerne un procédé pour décaler en fréquence le module de la fonction de transfert d'un filtre du type numérique et à structure transverse ; elle concerne également des dispositifs pour mettre en oeuvre ledit procédé.

Les filtres de fréquence de signaux électriques sont utilisés dans de nombreux domaines de l'électronique et notamment dans le traitement des signaux radar pour éliminer par exemple les échos fixes ou pour détecter des échos ayant des caractéristiques déterminées telles qu'une vitesse radiale. Ce mode de traitement est par exemple utilisé dans les radars Doppler cohérents à impulsions à vitesse ambiguë constante qui permettent, en mettant à profit l'effet Doppler, de déceler les obstacles mobiles qui donnent naissance à des signaux radar de faible amplitude au milieu d'obstacles fixes correspondant à des signaux radar de grande amplitude. En effet, dans ces radars à impulsions les ondes reçues après réflexion sur les obstacles mobiles sont affectés d'une phase qui varie d'une période de répétition à la suivante alors que les ondes reçues des obstacles fixes ne présentent pas une telle variation du déphasage. De ce fait, les signaux correspondant aux obstacles mobiles ont, après démodulation, des composantes qui varient sinusoïdalement à une fréquence fd appelée fréquence Doppler, qui est liée à la vitesse radiale v et à la longueur d'onde e du radar par la formule Fd = 2v/e. Les signaux qui correspondent à des obstacles fixes ont une amplitude constante et leur spectre est constitué par une série de raies discrètes aux fréquences O,Fr 2Fr,...nFr, Fr étant la fréquence de répétition des impulsions émises. Par ailleurs, le spectre des signaux correspondant à des obstacles mobiles se compose de raies discrètes du type mFr -+Fd.

On comprend alors qu'il est possible d'éliminer les signaux correspondant aux obstacles fixes en utilisant un filtre d'élimination des échos fixes qui ne laisse pas passer les signaux de fréquence O, Fr, 2Fr,...nFr. Il est également souhaitable d'éliminer dans certains radars, tels que les radars de surveillance du trafic aérien, les obstacles mobiles qui présentent des vitesses Doppler faibles par rapport aux vitesses des échos auxquels on s'intéresse, par exemple les nuages, ou encore des obstacles fixes fluctuants qui présentent une certaine vitesse Doppler, tels que les arbres agités par le vent. Ces différents échos parasites à faible vitesse sont mieux connus sous le vocable anglo-saxon de "clutter" que l'on a traduit par le terme "fouillis". Ces exemples montrent qu'il serait avantageux de disposer dans le domaine des radars de filtres dont on pourrait modifier aisément et simplement la fonction de transfert le long de l'axe des fréquences pour éliminer non seulement les échos fixes ou pseudo-fixes mais également ceux dont la vitesse radiale est très différente de celle des cibles auxquelles on s'intéresse.

Dans les radars, les filtres sont souvent réalisés sous forme numérique, c'est-à-dire que les signaux à filtrer sont échantillonnés à une fréquence égale à la fréquence de répétition des impulsions émises par le radar, puis l'amplitude des échantillons est codée de manière à obtenir une succession de codes numériques; enfin, ces codes sont multipliés par des coefficients dont les valeurs définissent les caractéristiques du filtrage à obtenir.

Ces filtres dits numériques sont réalisés par exemple à l'aide de mémoires disposées en série qui enregistrent chacune les codes de tous les échantillons d'une période de répétition, de circuits multiplicateurs disposés à la sortie desdites mémoires pour multiplier les codes lus dans la mémoire associée par un coefficient approprié et d'un circuit d'addition pour effectuer la sommation des codes résultant des multiplications.

De tels filtres numériques peuvent être utilisés dans des domaines autres que celui des radars, par exemple dans celui des signaux haute-fidélité, notamment lorsque de tels signaux sont sous forme numérique. Dans ces domaines, il existe aussi un besoin de modifier la fonction de transfert des filtres sur l'axe des fréquences sans pour autant modifier profondément la structure des filtres, par exemple pour étendre la bande de réjection du filtre.

Un but de la présente invention est donc de mettre en oeuvre un procédé qui permet, dans un filtre transverse, de décaler en fréquence le module de la fonction de transfert dudit filtre.

Un autre but de l'invention est de réaliser des dispositifs de mise en oeuvre du procédé qui, pour certaines valeurs du décalage en fréquence, soient simples à réaliser.

L'invention se rapporte à un procédé pour décaler en fréquence d'une valeur Fd le module de la fonction de transfert d'un filtre transverse à n cellules dont les coefficients de multiplication sont KO... Ki... Kn caractérisé en ce qu'il consiste à multiplier le coefficient de rang i par un facteur

$$e^{j(n-i)r}$$

avec i variant de o à n et

$$r = 2\pi Fd.Tr$$

si Tr est la période de répétition des échantillons appliqués au filtre transverse de manière à obtenir de nouveaux coefficients K'O...K'i...K'n.

D'autres caractéristiques et avantages de la présente invention apparaîtront à la lecture de la description suivante d'exemples particuliers de réalisation, ladite description étant faite en relation avec les dessins joints dans lesquels :

– la figure 1 est un schéma de principe d'un filtre transverse d'élimination des échos fixes ,

– la figure 2 est un diagramme montrant le module de la fonction de transfert du filtre transverse de la figure 1,

– la figure 3 est un diagramme vectoriel montrant deux positions d'un vecteur signal radar dans le plan complexe,

– la figure 4 est un schéma de la structure canonique d'un filtre transverse selon l'invention,

– la figure 5 est un diagramme montrant le module de la fonction de transfert d'un filtre transverse selon l'invention, qui élimine les échos de fréquences Doppler voisines de -Fr/4,

– la figure 6 est un diagramme montrant le module de la fonction de transfert d'un filtre transverse selon l'invention qui élimine les échos de fréquences Doppler voisines de +Fr/4 et la figure 7 est un schéma de réalisation de deux filtres transverses aux fréquences +Fr/4 et -Fr/4.

L'invention sera décrite dans une application particulière qui est celle du filtrage de signaux radar.

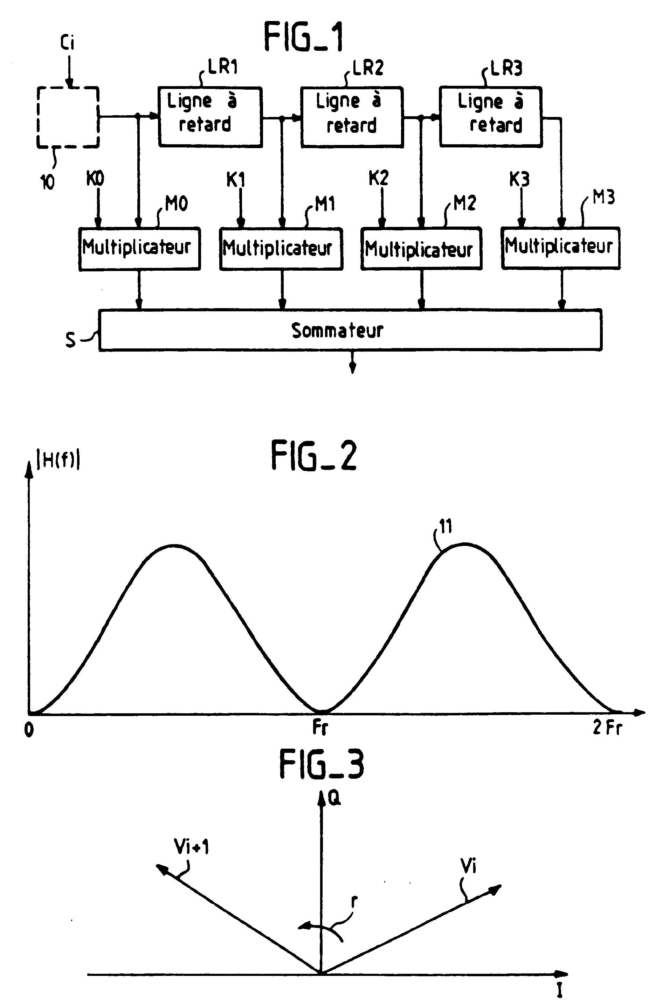

Dans les traitements de ces signaux, il est connu de les filtrer, notamment pour éliminer les échos fixes, en utilisant un dispositif dont le schéma de principe est donné par la figure 1. Ce dispositif comprend plusieurs lignes à retard, par exemple trois, LR1, LR2 et LR3 disposées en série, chaque ligne à retard introduisant un retard égal à la période de répétition Tr des impulsions émises de fréquence Fr. Chaque sortie de ligne à retard ainsi que l'entrée de la première LR1 est connectée respectivement à un circuit de multiplication ou de pondération MO, M1, M2 et M3 dans lequel l'amplitude du signal est multipliée ou pondérée respectivement par un coefficient K0, K1, K2, et K3. Les sorties des circuits de multiplication sont connectées à un circuit de sommation S qui effectue la somme des signaux pondérés de manière à obtenir un signal filtré. Pour éliminer les échos fixes les valeurs des coefficients K0, K1, K2 et K3 peuvent être respectivement 1, -3, 3 et -1 et la fonction de transfert en fréquence d'un tel filtre est de la forme

$$\left| \sin \pi Fd.Tr \right|^3$$

formule dans laquelle Fd est la fréquence Doppler de l'écho. Le module de la courbe de réponse en fréquence d'un tel filtre est donné par le diagramme de la figure 2. Dans le domaine des radars, un tel filtre est connu sous le nom de filtre transverse et est du type à annulation sur quatre impulsions, ce qui correspond à l'expression anglo-saxonne de "four-pulse canceler transverse filter".

Dans les radars modernes, un tel filtre est réalisé de manière numérique, ce qui signifie que les signaux vidéo-fréquence du radar sont échantillonnés à la fréquence Fr, et codés numériquement pour obtenir des codes $X_i$. Ces codes sont enregistrés dans des mémoires qui réalisent les lignes à retard LR1, LR2, et LR3 de la figure 1. Les circuits de multiplication MO, M1, M2 et M3 ainsi que le circuit de sommation S sont également réalisés de manière numérique de sorte que pour un code $X_i$ à l'entrée de la ligne à retard ou mémoire LR1, on obtient un code $S_i$ à la sortie du circuit S.

Plus précisément, à un instant donné ti+3, le signal $S_{i+3}$ à la sortie du circuit de sommation S sera donné par :

$$S_{i+3} = KO.X_{i+3} + K1.X_{i+2} + K2.X_{i+1} + K3 X_i$$

formule dans laquelle :

$X_i$ est l'amplitude de l'échantillon à l'instant t de la récurrence de rang (i)

$X_{i+1}$ est l'amplitude de l'échantillon à l'instant t de la récurrence de rang (i + 1) c'est-à-dire une période Tr plus tard,

$X_{i+2}$ est l'amplitude de l'échantillon à l'instant t de la récurrence de rang (i + 2) c'est à dire deux périodes Tr plus tard,

$X_{i+3}$ est l'amplitude de l'échantillon à l'instant t de la récurrence de rang (i + 3) c'est-à-dire trois périodes Tr plus tard.

Les échantillons $X_i$ à $X_{i+3}$ correspondent donc à un signal radar provenant d'une case de distance située à une distance déterminée de l'antenne du radar égale à t/C si C est la vitesse de la lumière.

Ce que l'invention propose de réaliser est de décaler la fonction de transfert de ce filtre, dont la réponse en fréquence est montrée sur la figure 2, le long de l'axe des fréquences d'une valeur f, ce décalage étant obtenu de manière simple avec un minimum de moyens supplémentaires.

La figure 3 permet de comprendre la démarche de l'invention. Sur cette figure, un signal radar $X_i$ à la récurrence i peut être représenté sous la forme d'un vecteur $V_i$ défini par ses composantes I et Q dans le plan complexe : $X_i = I_i + JQ_i$. A la récurrence suivante (i + 1), le vecteur sera devenu $V_{i+1}$ et correspondra au vecteur $V_i$ mais avec une rotation $r = 2\pi Fd/Fr$ si Fd est la fréquence Doppler de l'écho. On comprendra alors que cet écho serait vu comme un écho fixe si, à chaque récurrence, on le déphasait de l'angle r dont il aurait tourné, ce qui revient à multiplier le signal radar :

$$X_i \text{ par } 1$$

$$X_{i+1} \text{ par } e^{-jr}$$
$$X_{i+2} \text{ par } e^{-2jr}$$
$$X_{i+3} \text{ par } e^{-3jr}$$

On aurait ainsi obtenu une translation de fréquence du filtre d'élimination des échos fixes d'une valeur Fd. Une manière pour réaliser une telle translation est d'effectuer les multiplications à l'entrée du filtre transverse de la figure 1, c'est-à-dire en faisant précéder la ligne à retard LR1 d'un circuit de multiplication 10 qui a été représenté par un rectangle en tirets. Une telle solution conduit à un circuit de multiplication 10 qui est assez complexe car le coefficient change à chaque récurrence et qui est assez coûteux en nombre de circuits logiques et en temps de traitement.

Dans le dispositif de l'invention, un tel circuit de multiplication 10 , n'est plus nécessaire et est remplacé par de nouvelles valeurs K'0, K'1, K'2, et K'3 des coefficients de multiplication utilisés dans les circuits M0 à M3, valeurs qui sont fixes et qui, pour certaines valeurs de la fréquence Fd sont faciles à réaliser de manière numérique.

Les développements mathématiques qui vont suivre ont pour but de déterminer les coefficients K'0 à K'3. A cet effet, il est fait appel à la transformée en z qui est par exemple définie dans le livre intitulé "LES FILTRES NUMERIQUES" de R. BOITE et H. LEICH et édité par MASSON en 1980 - chapitre II.

La transformée en z d'un signal à temps discret $(x_n)$ est définie par la série :

$$\sum_{n=-\infty}^{+\infty} x_n\ z^{-n} \qquad \text{notée } Z\left[(x_n)\right]$$

Dans le cas d'un signal radar, $x_n$ correspond à la suite des échantillons séparés l'un de l'autre d'une période de répétition Tr.

Les propriétés de la transformée en z permettent de démontrer que la fonction de transfert H(z) du filtre de la figure 1 (sans le circuit multiplicateur 10) s'écrit sous la forme :

$$H(z) = K0 + K1.z^{-1} + K2.z^{-2} + K3.z^{-3} \quad (2)$$

Si l'on introduit le circuit multiplicateur 10, elle s'écrit sous la forme :

$$Hi(z) = KO.C_{i+3} + K1.C_{i+2}.z^{-1} + K2.C_{i+1}.z^{-2} + K3.C_i.z^{-3}$$

forme dans laquelle $Ci = (e^{jr})^i = (e^{j2\pi Fd/Fr})^i$

Le module Hi(z) est alors donné par

$$Hi(z) = KO.e^{j3r} + K1.e^{j2r}.z^{-1} + K2.e^{jr}.z^{-2} + K3.z^{-3}$$

ce qui correspond à un filtre de fonction de transfert H'(z) tel que

$$H'(z) = KO.e^{j3r} + K1.e^{j2r}.z^{-1} + K2.e^{jr}.z^{-2} + K3.z^{-3} \quad (3)$$

La comparaison des formules (2) et (3) montre que pour réaliser le décalage en fréquence fd du module de la fonction de transfert, il est suffisant de modifier les coefficients des circuits multiplicateurs M0 à M3 pour qu'ils deviennent

$$K'0 = K0.e^{j3r}$$
$$K'1 = K1.e^{j2r}$$
$$K'2 = K2.e^{jr}$$
$$K'3 = K3$$

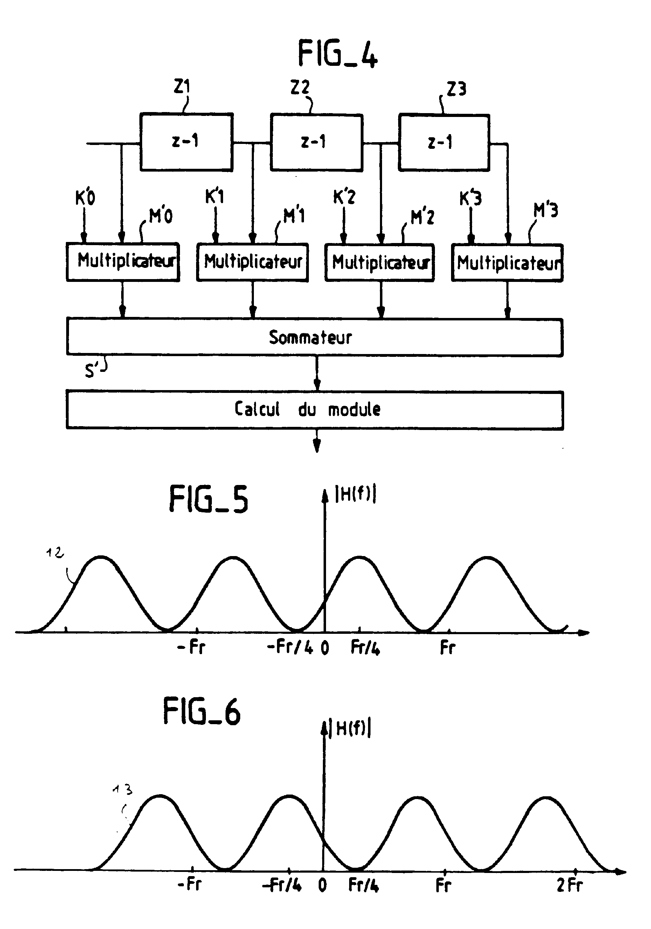

La figure 4 donne la structure canonique d'un tel filtre transverse dans le cas d'une pondération faite sur quatre impulsions. Sur cette figure, les lignes à retard LR1 à LR3 de la figure 1 sont schématisées par des opérateurs Z1 à Z3 en série qui réalisent chacun la transformée $z^{-1}$, ce qui correspond à effectuer un retard Tr de chaque échantillon $X_i$ car :

$$z^{-1} = e^{-j2\pi Fd.Tr}$$

L'entrée du circuit opérateur Z1 ainsi que les sorties des circuits opérateurs Z1, Z2 et Z3 sont connectés à des circuits multiplicateurs M'0 à M'3 qui effectuent respectivement la multiplication par les coefficients K'0 à K'3. Les sorties des circuits multiplicateurs M'0 à M'3 sont connectés à un circuit d'addition S' qui fournit un signal filtré $S'_{i+3}$ défini par :

$$S'_{i+3} = K'0.X_{i+3} + K'1.X_{i+2} + K'2.X_{i+3} + K3.X_i$$

c'est-à-dire un signal dans lequel ont été éliminés les échos ayant des fréquences Doppler Fd.

La description de l'invention a été faite dans le cas particulier d'un filtre transverse traitant quatre impulsions mais il est clair que l'invention peut être mise en oeuvre pour un nombre d'impulsions quelconque. Ainsi, pour un nombre L d'impulsions à traiter simultanément, on a les fonctions de transfert en z suivantes selon les structures :

(A) structure classique d'élimination des échos fixes :

$$H(z) = \sum_{p=0}^{L} K_p . z^{-p}$$

(B) structure avec multiplications en tête

$$H_i(z) = \sum_{p=0}^{L} (e^{jr})(L-p)i . K_p . z^{-p}$$

(C) structure avec multiplication en sortie

$$H'(z) = \sum_{p=0}^{L} e^{jr(L-p)} . K_p . z^{-p}$$

On constate alors que $H_i(z)$ et $H'(z)$ ont le même module, ce qui signifie que l'on réalise le même filtrage avec la structure (C) qu'avec la structure (B) si l'on ne s'intéresse qu'au module, mais dans la structure (C) les coefficients ne dépendent plus du rang de l'échantillon dans la période de répétition et sont donc des valeurs fixes.

On remarque que, pour certaines valeurs de la fréquence Doppler Fd par rapport à la fréquence de répétition Fr, on obtient des valeurs des coefficients K'0 à K'3 qui sont des nombres entiers conduisant à des multiplications simples. Il en est ainsi lorsque Fd est égale à +Fr/4 ou à -Fr/4 ; dans le premier cas, les quatre coefficients K'0 à K'3 peuvent être respectivement égaux à l'un des quatre groupes suivants

    – (-j, 3, 3j, -1)
    – (1, 3j, -3, -j)
    – (j, -3, -3j, 1)
    – (-1, -3j, 3, j)

Dans le deuxième cas, ils peuvent être respectivement égaux à :

    – (j, 3, -3j, -1)
    – (1,-3j, -3, j)
    – (-j, -3, 3j, 1)
    – (-1, 3j, 3, -j)

Dans le premier cas, le module de la fonction de transfert en fréquence H'(f) est donné par la courbe 12 de la figure 5 qui correspond à la courbe 11 d'élimination des échos fixes de la figure 2, mais déplacée de -Fr/4 sur l'axe des fréquences. Une telle fonction de transfert, dont le maximum de transmission est à +Fr/4 permet d'éliminer les échos correspondant aux fréquences Doppler voisines de -Fr/4.

Dans le second cas, le module de la fonction de transfert en fréquence H'(f) est donné par la courbe 13 de la figure 6 qui correspond à la courbe 11 d'élimination des échos fixes mais déplacée de +Fr/4 sur l'axe des fréquences. Une telle fonction de transfert dont le maximum de transmission est à -Fr/4 permet au filtre d'éliminer les échos correspondant aux fréquences Doppler voisines de +Fr/4.

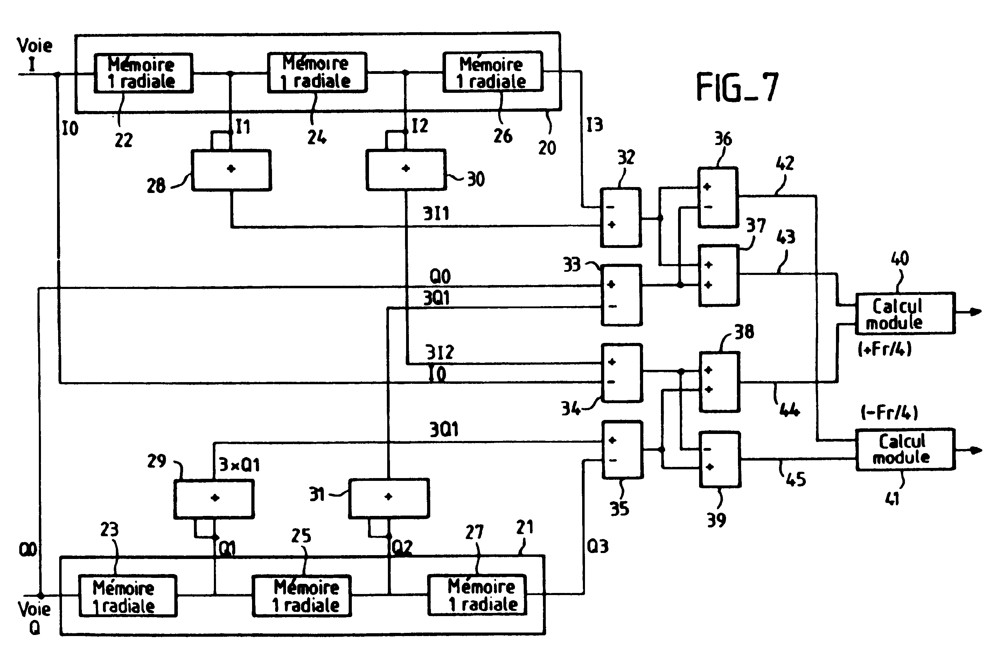

La figure 7 est un schéma d'un dispositif numérique de filtrage qui met en oeuvre le procédé de l'invention dans le cas de décalages simultanés en fréquence de +Fr/4 et -Fr/4 avec un traitement sur quatre impulsions à l'aide de trois mémoires réalisant chacune une ligne à retard.

Le signal à filtrer est présenté sous la forme de ses deux composantes réelle I et imaginaire Q qui sont d'abord traitées dans deux voies séparées puis dans une partie commune. Chaque voie séparée comprend une mémoire 20 (ou 21) qui est constituée, dans le cas d'un traitement simultané sur quatre échantillons, de trois mémoires élémentaires identiques 22, 24, 26 (ou 23, 25, 27) qui sont prévues pour enregistrer chacune, dans le cas d'un signal radar, les codes des échantillons correspondant à une période de répétition Tr. Les sorties des mémoires 22 et 24 (ou 23 et 25) sont connectées respectivement à des circuits additionneurs 28 et 30 (ou 29 et 31) qui réalisent l'opération multiplication par le coefficient 3.

La partie commune comprend des circuits additionneurs 32 à 39 et deux circuits de calcul de module. Les circuits additionneurs 32 à 35 et 36, 39, ont une entrée directe + et une entrée complémentaire - qui réalise le complément du code qui lui est appliqué. De manière plus précise, les entrées (-) des circuits additionneurs 32 à 35 sont connectées respectivement :

– à la sortie de la mémoire 26,
– à la sortie du circuit additionneur 31,
– à l'entrée de la mémoire 22, et
– à la sortie de la mémoire 27.

De même, les sorties (+) des circuits additionneurs 32 à 35 sont connectées respectivement :

– à la sortie du circuit additionneur 28,
– à l'entrée de la mémoire 23,
– à la sortie du circuit additionneur 30, et
– à la sortie du circuit additionneur 29.

Chaque sortie des circuits additionneurs 32 à 35 est connectée à une des deux entrées d'un des circuits additionneurs 36 à 39. Ainsi, la sortie du circuit additionneur 32 est connectée aux entrées (+) des circuits additionneurs 36 et 37 ; la sortie du circuit additionneur 33 est connectée à l'entrée (-) du circuit 36 et à l'entrée (+) du circuit 37 ; la sortie du circuit 34 est connectée à l'entrée (+) du circuit 38 et à l'entrée (-) du circuit 31 ; enfin, la sortie du circuit 35 est connectée à l'entrée (+) des circuits 38 et 39.

Les sorties 42 et 45 des circuits 36 et 39 sont connectées aux deux entrées du circuit de calcul du module 41 tandis que les sorties 43 et 44 sont connectées aux deux entrées du circuit de calcul de module 40.

Si on appelle respectivement I0, I1, I2 et I3 les codes des échantillons à l'entrée de la mémoire 22 et aux sorties des mémoires 22, 24 et 26 et Q0, Q1, Q2 et Q3 les codes des échantillons à l'entrée de la mémoire 21 et aux sorties des mémoires 23, 25 et 27, on peut voir que l'on a les codes suivants à la sortie des circuits 36 à 39.

– à la sortie 42 du circuit additionneur 36 :
    - I3 + 3I1 - Q0 + 3Q2 ;
– à la sortie 45 du circuit additionneur 39 :
    - Q3 + 3Q1 + I0 - 3I2 ;
– à la sortie 43 du circuit additionneur 37 :
    - I3 + 3I1 +Q0 - 3Q2 ;
– à la sortie 44 du circuit additionneur 38 :
    - Q3 + 3Q1 - I0 +3I2.

On a montré ci-dessus que, pour obtenir un filtre dit +Fr/4 il fallait, selon l'invention, multiplier les échantillons complexes X3, X2, X1, X0 par les coefficients respectifs -1, 3j, 3, -j et faire une sommation des résultats des multiplications c'est-à-dire obtenir :

-1(I3+jQ3) + 3j(I2+jQ2) + 3(I1+JQ1) - j(Io+JQo)

soit :

-I3 + 3I1 + Q0 - 3Q2 +j(-Q3+3Q1-I0+3I2),

ce qui correspond pour la partie réelle à la sortie 43 du circuit 37 et pour la partie imaginaire à la sortie 44 du circuit 38.

En ce qui concerne le filtre dit -Fr/4, les coefficients respectifs qui ont été indiqués ci-dessus sont -1, -3j, 3 et j, pour les échantillons complexes X3, X2,X1, X0. A la sortie du circuit de sommation S' de la figure 4, on obtient :

-1 (I3+jQ3) - 3j(I2+jQ2) + 3(I1+JQ1) + j(Io+JQo) soit : - I3 + 3I1 - Q0 + 3Q2 + j (-Q3 + 3Q1 + I0 - 3I2), ce qui correspond pour la partie réelle à la sortie 42 du circuit 36 et pour la partie imaginaire à la sortie 45 du circuit 39.

En conséquence de ce qui précède, le circuit de calcul du module 40 donne donc le module du signal correspondant au filtre +Fr/4 tandis que le circuit 41 donne le module du signal correspondant au filtre -Fr/4. La description qui vient d'être faite en relation avec la figure 7 montre que l'application de l'invention à des cas particuliers de filtres permet d'aboutir à des dispositifs numériques simples, faciles à réaliser et n'utilisant que des circuits élémentaires.

L'invention a été décrite en relation avec une application particulière dans le domaine des radars. Cependant on comprend que l'invention s'applique au filtrage de tous types de signaux électriques à condition de les échantillonner à une fréquence au moins égale à deux fois la fréquence maximum du spectre utile de ma-

EP 0 333 566 B1

nière à obtenir les échantillons Xi séparés par des intervalles de temps égaux à la période d'échantillonnage.

Bien entendu, pour obtenir un filtre ayant une fonction de transfert donnée en mettant en oeuvre la présente invention, il est possible de mettre en parallèle plusieurs filtres transverses selon l'invention, chaque filtre transverse ayant une fonction de transfert appropriée de manière que la somme des fonctions de transfert aboutisse à la fonction de transfert globale recherchée.

**Revendications**

1 - Procédé pour décaler en fréquence d'une valeur Fd le module de la fonction de transfert d'un filtre transverse à n cellules dont les coefficients de multiplication sont KO...Ki...Kn, caractérisé en ce qu'il consiste à multiplier le coefficient de rang i par facteur $e^{j(n-i)r}$ avec i variant de o à n et r = $2\pi$Fd.Tr si Tr est la période de répétition des échantillons appliqués au filtre transverse de manière à obtenir de nouveaux coefficients K'O... K'i...K'n

2 - Procédé selon la revendication 1 pour décaler le module de la fonction de transfert d'une fréquence +Fr/4 dans un filtre transverse à trois cellules, caractérisé en ce que les coefficients K'O, K'1, K'2 et K'3 peuvent avoir respectivement les valeurs de l'un des quatre groupes suivants :
 – (-j, 3, 3j, -1)
 – (1, 3j, -3, -j)
 – (j, -3, -3j, 1)
 – (-1, -3j, 3, j)

3 - Procédé selon la revendication 1 pour décaler le module de la fonction de transfert d'une fréquence -Fr/4 dans un filtre transverse à trois cellules, caractérisé en ce que les coefficients K'O, K'1, K'2 et K'3 peuvent avoir respectivement les valeurs de l'un des groupes suivants :
 – (j, 3, -3j, -1)
 – (1, ⁻3j, -3, j)
 – (-j, -3, 3j, 1)
 – (-1, 3j, 3, -j)

4 - Dispositif pour mettre en oeuvre le procédé selon les revendications 2 et 3 de manière à filtrer un signal complexe I + jQ dont les composantes sont présentées sous forme de codes numériques successifs séparés par des intervalles de temps Tr, caractérisé en ce qu'il comprend :
 – une première voie et une deuxième voie de traitement pour traiter respectivement les codes successifs des composantes réelle I et imaginaire Q, chaque voie comportant trois mémoires (22, 24, 26 ou 23, 25, 27) prévues pour enregistrer chacune tous les codes successifs apparaissant pendant une durée Tr et pour être lus de manière à présenter simultanément en même temps qu'un code Io ou Qo, trois autres codes I1 ou Q1, I2 ou Q2, I3 ou Q3 correspondant au même signal à filtrer,
 – des circuits additionneurs (28 à 39) connectés pour recevoir les codes Io à I3 et QO à Q3 fournis respectivement par les premières et deuxièmes voies de traitement et pour calculer, en utilisant le module d'un groupe de coefficients définis dans l'une et l'autre revendications 2 et 3, les parties réelle et imaginaire d'un signal filtré correspondant au décalage +Fr/4 et d'un signal filtré correspondant au décalage -Fr/4, et
 – des circuits 40 et 41 de calcul du module des deux signaux filtrés.

5 - Dispositif selon la revendication 4, caractérisé en ce que les circuits additionneurs (28 à 39) sont prévus pour effectuer les sommes suivantes :
 . -I3 + 3I1 - Q0 + 3Q2 qui correspond à la partie réelle du signal de sortie du filtre décalé de +Fr/4,
 . -Q3 + 3Q1 + IO - 3I2 qui correspond à la partie imaginaire du signal de sortie du filtre décalé de +Fr/4,
 . -I3 + 3I1 + QO - 3Q2 qui correspond à la partie réelle du signal de sortie du filtre décalé de -Fr/4, et
 . - Q3 + 3Q1 - IO + 3I2 qui correspond à la partie imaginaire du signal de sortie du filtre décalé de -Fr/4.

**Claims**

1. - Method for frequency-shifting, by a value Fd, the modulus of the transfer function of an n-cell transverse filter whose multiplication coefficients are KO...Ki...Kn, characterised in that it consists in multiplying the coefficient of rank i by a factor $e^{j(n-i)r}$ with i varying from o to n and r = $2\pi$Fd.Tr if Tr is the repetition period of the samples applied to the transverse filter in such a way as to obtain new coefficients K'O... K'i...K'n.

2. - Method according to Claim 1 for shifting the modulus of the transfer function by a frequency +Fr/4 in

7

a three-cell transverse filter, characterised in that the coefficients K'O, K'1, K'2 and K'3 can respectively have the values of one of the four following groups:

– (-j, 3, 3j, -1)
– (1, 3j, -3, -j)
– (j, -3, -3j, 1)
– (-1, -3j, 3, j)

3. - Method according to Claim 1 for shifting the modulus of the transfer function by a frequency -Fr/4 in a three-cell transverse filter, characterised in that the coefficients K'O, K'1, K'2 and K'3 can respectively have the values of one of the following groups:

– (j, 3, -3j, -1)
– (1, -3j, -3, j)
– (-j, -3, 3j, 1)
– (-1, 3j, 3, -j)

4. - Device for implementing the method according to Claims 2 and 3 so as to filter a complex signal I + jQ whose components are presented in the form of successive digital codes separated by time intervals Tr, characterised in that it comprises:

– a first processing channel and a second processing channel for respectively processing the successive codes of the real I and imaginary Q components, each channel comprising three memories (22, 24, 26 or 23, 25, 27) provided for registering each of the successive codes appearing over a duration Tr and for being read so as simultaneously to present, at the same time as a code Io or Qo, three other codes I1 or Q1, I2 or Q2, I3, or Q3, corresponding to the same signal to be filtered,
– adding circuits (28 to 39) connected for receiving the codes Io to I3 and QO to Q3 supplied respectively by the first and second processing channels and for calculating, using the modulus of a group of coefficients defined in both of Claims 2 and 3, the real and imaginary parts of a filtered signal corresponding to the shifting +Fr/4 and of a filtered signal corresponding to a shifting -Fr/4, and
– circuits 40 and 41 for calculating the modulus of the two filtered signals.

5. Device according to Claim 4, characterised in that the adding circuits (28 to 39) are provided to effect the following sums:

. -I3 + 3I1 - Q0 + 3Q2 which corresponds to the real part of the output signal of the filter shifted by +Fr/4,
. -Q3 + 3Q1 + IO - 3I2 which corresponds to the imaginary part of the output signal of the filter shifted by +Fr/4,
. -I3 + 3I1 + QO - 3Q2 which corresponds to the real part of the output signal of the filter shifted by -Fr/4, and
. -Q3 + 3Q1 - IO + 3I2 which corresponds to the imaginary part of the output signal of the filter shifted by -Fr/4.

## Patentansprüche

1. Verfahren zur Frequenzverschiebung des Moduls der Übertragungsfunktion eines transversalen Filters mit n Gliedern um einen Frequenzwert Fd, die die Multiplikationskoeffizienten KO...Ki...Kn aufweisen, dadurch gekennzeichnet, daß es darin besteht, den i-ten Koeffizienten mit einem Faktor $e^{j(n-i)r}$ beruht zu multiplizieren, mit i variierend von O bis n und $r = 2\pi Fd \cdot Tr$, wenn Tr die Wiederholungsperiode der an das transversale Filter angelegten Abtastwerte ist, so daß neue Koeffizienten K'O...K'i...K'n erhalten werden.

2. Verfahren nach Anspruch 1 zur Frequenzverschiebung des Moduls der Übertragungsfunktion um eine Frequenz + Fr/4 in einem transversalen Filter mit drei Gliedern, dadurch gekennzeichnet, daß die Koeffizienten K'O, K'1, K'2 und K'3 jeweils die Werte aus einer der nachstehenden vier Gruppen haben können:

– ( -j, 3, 3j, -1)
– ( 1, 3j, -3, -j)
– ( j, -3,-3j, 1)
– ( -1,-3j, 3, j)

3. Verfahren nach Anspruch 1 zur Frequenzverschiebung des Moduls der Übertragungsfunktion um eine Frequenz -Fr/4 in einem transversalen Filter mit drei Gliedern, dadurch gekennzeichnet, daß die Koeffizienten K'O, K'1, K'2 und K'3 jeweils die Werte aus einer der nachstehenden Gruppen haben können:

– ( j, 3,-3j, -1)

EP 0 333 566 B1

– ( 1,-3j, -3, j)
– ( -j, -3, 3j, 1)
– ( -1, 3j, 3, -j)

4. Vorrichtung zum Durchführen des Verfahrens nach Anspruch 2 und 3, in der Art, daß ein komplexes Signal I + jQ, dessen Komponenten in Form fortlaufender, durch Zeitintervalle Tr getrennter, digitaler Codes vorliegen, gefiltert wird, dadurch gekennzeichnet, daß sie enthält:
– einen ersten Verarbeitungspfad und einen zweiten Verarbeitungspfad zum Verarbeiten jeweils der aufeinanderfolgenden Codes des Realteils I und des Imaginärteils Q, wobei jeder Weg drei Speicher (22, 24, 26 oder 23, 25, 27) umfaßt, die zum Einschreiben aller aufeinanderfolgender, während einer Dauer Tr erscheinender Codes in jeden von ihnen und zum Auslesen in der Art vorgesehen sind, daß simultan, zur gleichen Zeit wie ein Code Io oder Qo, drei weitere Codes I1 oder Q1, I2 oder Q2, I3 oder Q3 dargestellt werden, die zum selben Filtersignal gehören,
– Addierschaltungen (28 bis 39), die zum Empfang der jeweils von den ersten und zweiten Verarbeitungspfaden gelieferten Codes Io bis I3 und QO bis Q3 angeschlossen sind, zum Berechnen, unter Nutzung des Moduls einer in Anspruch 2 oder 3 bestimmten Koeffizientengruppe, der Realteile und der Imaginärteile eines Filtersignals, das zu einer Frequenzverschiebung + Fr/4 gehört, und eines Filtersignals, das zu einer Frequenzverschiebung -Fr/4 gehört, und
– Schaltungen 4O und 41 zum Berechnen des Moduls beider Filtersignale.

5. Vorrichtung nach Anspruch 4, dadurch gekennzeichnet, daß die Addierschaltungen (28 bis 39) zum Ausführen nachfolgender Summen vorgesehen sind:
. -I3 + 3I1 - QO + 3Q2, die zum Realteil des Filterausgangssignals gehört, das um +Fr/4 frequenzverschoben ist,
. -Q3 + 3Q1 + IO - 3I2, das zum Imaginärteil des Filterausgangssignals gehört, das um +Fr/4 frequenzverschoben ist,
. -I3 + 3I1 + QO - 3Q2, die zum Realteil des Filterausgangssignals gehört, das um -Fr/4 frequenzverschoben ist, und
. -Q3 + 3Q1 - IO + 3I2, die zum Imaginärteil des Filterausgangssignals gehört, das um -Fr/4 frequenzverschoben ist.

# FIG_1

Ci

| Ligne à retard (LR1) | Ligne à retard (LR2) | Ligne à retard (LR3) |

10

K0 — M0 — Multiplicateur

K1 — M1 — Multiplicateur

K2 — M2 — Multiplicateur

K3 — M3 — Multiplicateur

S — Sommateur

# FIG_2

|H(f)|

0        Fr        2 Fr

11

# FIG_3

Q

Vi+1

Vi

r

I

## FIG_4

## FIG_5

## FIG_6

FIG_7